# EUROPEAN PATENT APPLICATION

(11) **EP 4 478 414 A1**
(43) Date of publication of application: **18.12.2024**
(21) Application number: 23210194.9
(22) Date of filing: 15.11.2023
(51) Int. Cl.: H01L 27/02

(54) **TWO-TERMINAL INTEGRATED CIRCUIT DEVICE FOR ELECTROSTATIC DISCHARGE PROTECTION**

(30) Priority: 12.06.2023 US 202318332918
(71) Applicant: INTEL Corporation, Santa Clara, CA 95054 (US)
(72) Inventor: KOLLURU, Kalyan, Portland, 97214 (US); KAR, Ayan, Portland, 97229 (US)
(74) Representative: HGF

(57) **Abstract**

A two-terminal IC device may be used for ESD protection. The IC device may include a deep N-well may be between a P-type substrate and a group of wells that includes a first P-well, a second P-well, and a N-well. There may be another well between the second P-well and the N-well. A P-type semiconductor structure may be formed in the P-well. Two N-type semiconductor structures may be formed in the second P-well and the N-well, respectively. A contact of the P-type semiconductor structure may be electrically coupled to a contact of the N-type semiconductor structure in the second P-well. The two contacts may constitute the first terminal of the IC device. The contact of the N-type semiconductor structure in the N-well may constitute the second terminal of the IC device. The first P-well may have a greater dimension but lower dopant concentration than the second P-well or the N-well.

## Description

### Background

A field-effect transistor (FET), e.g., a metal-oxide-semiconductor (MOS) FET (MOSFET), is usually a three-terminal device that includes source, drain, and gate terminals and uses electric field to control current flowing through the device. A FET typically includes a semiconductor channel material, a source region and a drain region provided in the channel material, and a gate stack (also referred to as "gate") that includes at least a gate electrode material and may also include a gate dielectric material, the gate stack provided over a portion of the channel material between the source and the drain regions. Recently, FETs with non-planar architectures, such as FinFETs (also sometimes referred to as "wrap around gate transistors" or "tri-gate transistors") and nanosheet or nanoribbon FET (also sometimes referred to as "all-around gate transistors"), have been extensively explored as alternatives to transistors with planar architectures.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 illustrates an example integrated circuit (IC) device for electrostatic discharge (ESD) protection, according to some embodiments of the disclosure.
FIG. 2 illustrates a circuit diagram of an IC device with two terminals, according to some embodiments of the disclosure.
FIG. 3 illustrates a voltage-current curve of an IC device with two terminals, according to some embodiments of the disclosure.
FIG. 4 is a top view of an IC device with two terminals, according to some embodiments of the disclosure.
FIGS. 5A-5I illustrate a process of forming a two-terminal IC device, according to some embodiments of the disclosure.
FIGS. 6A-6B are top views of a wafer and dies that may facilitate one or more two-terminal IC devices for ESD protection, according to some embodiments of the disclosure.
FIG. 7 is a side, cross-sectional view of an example IC package that may include one or more two-terminal IC devices for ESD protection, according to some embodiments of the disclosure.
FIG. 8 is a cross-sectional side view of an IC device assembly that may include components having one or more two-terminal IC devices for ESD protection, according to some embodiments of the disclosure.
FIG. 9 is a block diagram of an example computing device that may include one or more components with one or more two-terminal IC devices, according to some embodiments of the disclosure.

### Detailed Description

The systems, methods, and devices of this disclosure each have several innovative aspects, no single one of which is solely responsible for all the desirable attributes disclosed herein. Details of one or more implementations of the subject matter described in this specification are set forth in the description below and the accompanying drawings.

Many IC devices, such as MOS devices, are usually susceptible to gate oxide breakdown and can fail prematurely during ESD events. Many currently available ESD protection solutions are circuit based. An example is SCR (Silicon Controlled Rectifier) triggered ESD solution. A SCR with external trigger circuity can be used in conjunction with a diode for ESD protection. For fail safe protection, large area diodes are normally used in conjunction with an SCR for ESD protection. An intrinsic SCR can have a very high snapback voltage, e.g., breakdown voltage of NW/PWjunction, which, in general, is larger than the oxide and junction breakdown voltages of the victim. Hence, a thick gate transistor can be used as a trigger for the SCR in order to induce turn on at a much lower voltage. However, many SCRs have high inherent overshoot and lower holding voltages, which can lead to a large voltage build ups on victim devices and risk of permanent turn on during transients at the pad node.

Another example is a stand-alone grounded gate NMOS (GGMOS) solution. During ESD events high current/voltage at the drain of the GGNMOS causes it to snapback as the bipolar junction transistor (BJT) turns on and the device begins to shunt the ESD current to ground, protecting the core circuit/buffers from the ESD stress. However, GGNMOS devices can be susceptible to gate oxide breakdown and fail prematurely during ESD events. This is due to high voltage ESD spike at drain that can induce gate oxide leakage and/or breakdown at the drain/oxide corner region. Adding series ballast resistance at the drain node helps to uniformly distribute the ESD current across all legs of the device to achieve higher ESD protection. A stand-alone GGMOS can be used with gate and source connected to ground node and drain connected to the exposed pin/pad.

Embodiments of the present disclosure may improve on at least some of the challenges and issues described above by providing two-terminal IC devices for ESD protection. A two-terminal IC device may be based on FET with a non-planar architecture and can serve as an ESD clamp for devices susceptible to ESD events.

In various embodiments of the present disclosure, a two-terminal IC device may include a deep N-well that is stacked between a substrate and a group of wells. The substrate may be a P-type substrate, based on which the deep N-well and the group of wells may be formed. The group of wells may include a first P-well, a second P-well, and a N-well, where semiconductor structures can be formed. For instance, a P-type semiconductor structure may be formed in the first P-well, a first N-type semiconductor structure may be formed in the second P-well, and a second N-type semiconductor structure may be formed in the N-well. The P-type semiconductor structure, first N-type semiconductor structure, or second N-type semiconductor structure may include one or more fins, nanoribbons, or other types of non-planar structures. A contact of the P-type semiconductor structure may be electrically coupled to a contact of the first N-type semiconductor structure. For instance, an electrically conductive structure may be electrically coupled to both the P-type semiconductor structure and the first N-type semiconductor structure. This may be one of the two terminals of the IC device. The terminal may be electrically coupled to a ground plane. A contact of the second N-type semiconductor structure may constitute the other terminal of the IC device, which may be electrically coupled to a power plane. The IC device may also include gates (e.g., metal gates, poly gates, etc.) over some or all the wells. The gates may be separated from each other by electrical insulators. A gate may be a floating gate.

The dimensions and dopant concentrations of the wells in the two-terminal IC device can be controlled to optimize key snapback characteristics of the two-terminal IC device, such as the breakdown voltage, trigger voltage, holding voltage, and so on. In some embodiments, the second P-well may be between the first P-well and the N-well. The IC device may further include another well that separates the second P-well from the N-well. A dimension of the first P-well may be larger than the corresponding dimension of the second P-well. A distance between an edge of the first P-well to an edge of the P-type semiconductor structure may be larger than a distance between an edge of the second P-well to an edge of the first N-type semiconductor structure. The second P-well may be more highly doped than the first P-well. The second P-well may also be more highly doped than the well between the second P-well and the N-well.

The present disclosure provides a solution to tune snapback characteristics of ESD protection devices by modulating doping at specific concentration and species, without the need of additional circuitry, to meet the requirement of the parent circuit. This solution can avoid false trigger during regular DC operation and prevent breakdown of victim devices in the parent circuit before it is too late to turn on ESD protection. The two-terminal IC devices can serve ESD protection needs for various circuits and topologies, such as open drain circuits, buck circuits, and so on.

It should be noted that, in some settings, the term "nanoribbon" has been used to describe an elongated semiconductor structure that has a substantially rectangular transverse cross-section (e.g., a cross-section in a plane perpendicular to the longitudinal axis of the structure), while the term "nanowire" has been used to describe a similar structure but with a substantially circular or square transverse cross-sections. In the following, a single term "nanoribbon" is used to describe an elongated semiconductor structure independent of the shape of the transverse cross-section. Thus, as used herein, the term "nanoribbon" is used to cover elongated semiconductor structures that have substantially rectangular transverse cross-sections (possibly with rounded corners), elongated semiconductor structures that have substantially square transverse cross-sections (possibly with rounded corners), elongated semiconductor structures that have substantially circular or elliptical/oval transverse cross-sections, as well as elongated semiconductor structures that have any polygonal transverse cross-sections.

In the following, some descriptions may refer to a particular source or drain (S/D) region or contact being either a source region/contact or a drain region/contact. However, unless specified otherwise, which region/contact of a transistor or diode is considered to be a source region/contact and which region/contact is considered to be a drain region/contact is not important because, as is common in the field of FETs, designations of source and drain are often interchangeable. Therefore, descriptions of some illustrative embodiments of the source and drain regions/contacts provided herein are applicable to embodiments where the designation of source and drain regions/contacts may be reversed.

As used herein, the term "metal layer" may refer to a layer above a substrate that includes electrically conductive interconnect structures for providing electrical connectivity between different IC components. Metal layers described herein may also be referred to as "interconnect layers" to clearly indicate that these layers include electrically conductive interconnect structures which may, but do not have to be, metal.

The systems, methods and devices of this disclosure each have several innovative aspects, no single one of which is solely responsible for all of the desirable attributes disclosed herein. Details of one or more implementations of the subject matter described in this specification are set forth in the description below and the accompanying drawings.

In the following detailed description, various aspects of the illustrative implementations may be described using terms commonly employed by those skilled in the art to convey the substance of their work to others skilled in the art. For example, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. If used, the terms "oxide," "carbide," "nitride," etc. refer to compounds containing, respectively, oxygen, carbon, nitrogen, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/- 10%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 8% of a target value, e.g., within +/- 5% of a target value or within +/- 2% of a target value, based on the context of a particular value as described herein or as known in the art. Also, the term "or" refers to an inclusive "or" and not to an exclusive "or."

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" or the phrase "A or B" means (A), (B), or (A and B). For the purposes of the present disclosure, the phrase "A, B, and/or C" or the phrase "A, B, or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

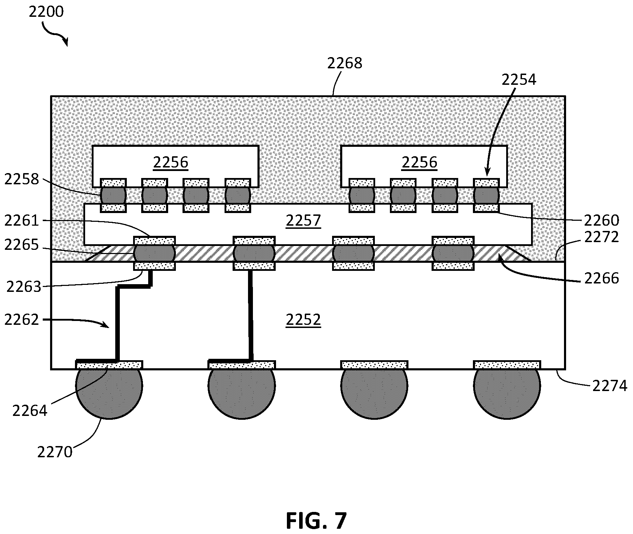

In the following detailed description, reference is made to the accompanying drawings that form a part hereof, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense. For convenience, if a collection of drawings designated with different letters are present, e.g., FIGS. 7A-7B, such a collection may be referred to herein without the letters, e.g., as "FIG. 7."

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of two-terminal IC devices as described herein.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various IC devices with two terminals as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

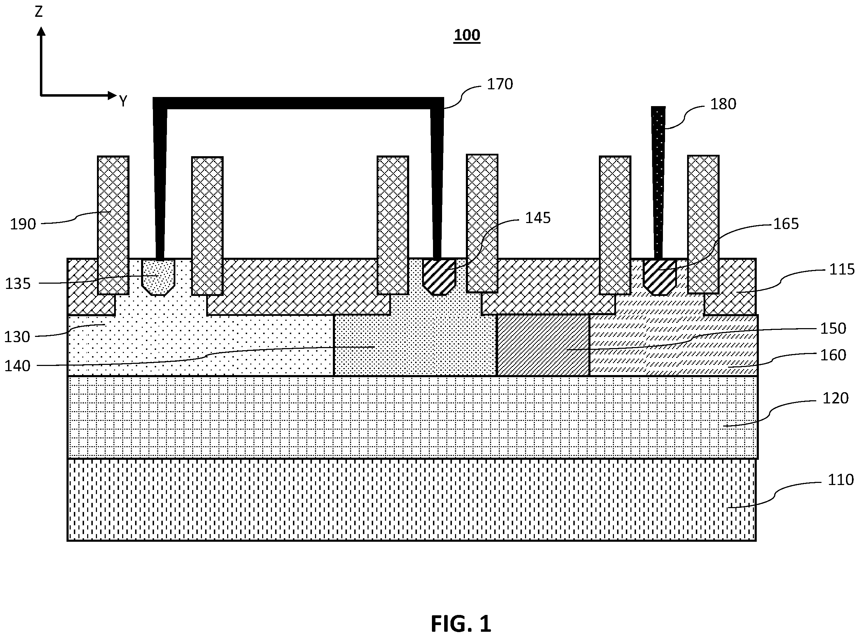

FIG. 1 illustrates an example IC device 100 for ESD protection, according to some embodiments of the disclosure. The IC device 100 includes a support structure 110, an electrical insulator 115, a deep N-well 120, a P-well 130, another P-well 140, a well 150, a N-well 160, a semiconductor structure 135, another semiconductor structure 145, yet another semiconductor structure 165, an electrically conductive structure 170, another electrically conductive structure 180, and a plurality of gate electrodes 190 (individually referred to as "gate electrode 190"). In other embodiments, the IC device 100 may include different, fewer, or more components.

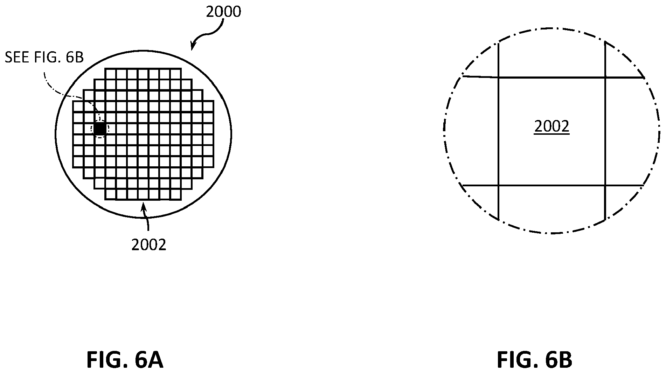

The support structure 110 may be any suitable structure, such as a substrate, a die, a wafer, or a chip, based on which semiconductor structures (e.g., the deep N-well 120, P-well 130, P-well 140, well 150, N-well 160, etc.) can be built. The support structure 110 may, e.g., be the wafer 2000 of FIG. 6A, discussed below, and may be, or be included in, a die, e.g., the singulated die 2002 of FIG. 6B, discussed below. In some embodiments, the support structure 110 may be a semiconductor substrate composed of semiconductor material systems including, for example, N-type or P-type materials systems. In some embodiments, the support structure 110 includes a doped semiconductor material, e.g., a semiconductor material with P-type dopants. The support structure 110 may be a P-type substrate.

In some embodiments, the semiconductor substrate may be a crystalline substrate formed using a bulk silicon or a silicon-on-insulator substructure. In other embodiments, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. In some embodiments, the substrate may be non-crystalline. In some embodiments, the support structure may be a printed circuit board (PCB) substrate.

Although a few examples of materials from which the support structure 110 may be formed are described here, any material that may serve as a foundation upon which an IC may be built falls within the scope of the present disclosure. In various embodiments, the support structure 110 may include any such substrate, possibly with some layers and/or devices already formed thereon, not specifically shown in the present figures. As used herein, the term "support" does not necessarily mean that it provides mechanical support for the IC devices/structures (e.g., transistors, capacitors, interconnects, and so on) built thereon. For example, some other structure (e.g., a carrier substrate or a package substrate) may provide such mechanical support and the support structure 110 may provide material "support" in that, e.g., the IC devices/structures described herein are build based on the semiconductor materials of the support structure 110. However, in some embodiments, the support structure 110 may provide mechanical support.

The deep N-well 120 separates the support structure 110 from the P-well 130, P-well 140, well 150, and N-well 160. The deep N-well 120 may include one or more N-doped semiconductor materials. In some embodiments, the deep N-well 120 may be formed based on a substrate including the support structure 110, e.g., by doping a portion of the substrate that is on top of the support structure 110. A dopant concentration (e.g., the concentration of N-type dopants in the deep N-well 120 may be in a range from approximately 5×10¹⁷ atoms/cm³ to approximately 1.7×10¹⁸ atoms/cm³.

The P-well 130 is over a portion of the deep N-well 120. The P-well 140 may be a P-doped semiconductor region that includes one or more semiconductor materials and one or more P-type dopants. In some embodiments, the P-well 130 may be formed based on a substrate including the support structure 110, e.g., by doping a portion of the substrate that is on top of the support structure 110 or on top of the deep N-well 120. The P-well 130 includes one or more P-doped semiconductor materials. A dopant concentration (e.g., the concentration of P-type dopants in the P-well 130 may be in a range from approximately 5×10¹⁶ atoms/cm³ to approximately 5×10¹⁷ atoms/cm³. In some embodiments, the P-well 140 may be doped by multiple doping steps at different energies. For instance, the first doping may be at 15-30 k, the second doping may be at 35-50 k, and the third doping may be at 50-70 k. The dopant may be a P-type dopant, such as Boron or other P-type dopants.

The P-well 140 is over another portion of the deep N-well 120. The P-well 140 may be a P-doped semiconductor region that includes one or more semiconductor materials and one or more P-type dopants. A dopant concentration (e.g., the concentration of P-type dopants in the P-well 140 may be in a range from approximately 1.5×10¹⁸ atoms/cm³ to approximately 3.5×10¹⁸ atoms/cm³. In some embodiments, the lengths and doping concentrations of these two P-wells 130 and 140 may be chosen to modulate the trigger voltage Vt1 of the IC device 100 by modulating the Rb resistance. In some embodiments, a dimension of the P-well 140 along the Y axis (represented by the dashed arrow in the P-well 140 in FIG. 1) is smaller than the corresponding dimension of the P-well 130 (represented by the dashed arrow in the P-well 130 in FIG. 1). The dimension of the P-well 130 may be in a range from approximately 300 nanometers (nm) to approximately 900 nm. The dimension of the P-well 140 may be smaller than the dimension of the P-well 130 by up to approximately 200 nm.

In some embodiments, the P-well 140 may be formed based on a substrate including the support structure 110, e.g., by doping a portion of the substrate that is on top of the support structure 110 or on top of the deep N-well 120 and is next to the P-well 130. In some embodiments, a dopant concentration of the P-well 140 may be higher than the dopant concentration of the P-well 130. In an embodiment, the dopant concentration of the P-well 140 may be approximately at least 2.5 times the dopant concentration of the P-well 130. For example, the dopant concentration of the P-well 140 may be approximately 2.5 to 6 times the dopant concentration of the P-well 130.

The well 150 may be a P-well, N-well, or an intrinsic well with no additional implants. In some embodiments, the well 150 may be formed based on a substrate including the support structure 110, e.g., by doping a portion of the substrate that is on top of the support structure 110 or on top of the deep N-well 120 and is next to the P-well 140. The well 150 can separate the P-wells 130 and 140 from the N-well 160. In some embodiments, the well 150 may have a dopant concentration that is lower than the dopant concentration of the P-well 140. For instance, the dopant concentration of the well 150 may be approximately half of the dopant concentration of the P-well 140 or even less. In an embodiment, the dopant concentration of the well 150 may be approximately 0 to 0.5 times the dopant concentration of the P-well 140 or even less.

The N-well 160 is a N-doped semiconductor region that includes one or more semiconductor materials and one or more N-type dopants. In some embodiments, the N-well 160 may be formed based on a substrate including the support structure 110, e.g., by doping a portion of the substrate that is on top of the support structure 110 or on top of the deep N-well 120 and is next to the well 150. In some embodiments, the N-well 160 may have a dopant concentration that is the same or substantially similar as the dopant concentration the P-well 140.

A portion of the P-well 130, P-well 140, well 150, or N-well 160 may be surrounded by the electrical insulator 115. The electrical insulator 115 may include a dielectric material, hysteretic material, and so on. Example dielectric material includes oxide (e.g., Si based oxides, metal oxides, etc.), high-k dielectric, and so on. Example hysteretic material include ferroelectric materials, antiferroelectric materials, etc.

The semiconductor structure 135 is at least partially in the P-well 130. The semiconductor structure 135 may be a P-type semiconductor structure. In some embodiments, the semiconductor structure 135 includes one or more semiconductor materials and one or more P-type dopants. The semiconductor structure 145 is at least partially in the P-well 140. The semiconductor structure 145 may be a P-type semiconductor structure. In some embodiments, the semiconductor structure 145 includes one or more semiconductor materials and one or more P-type dopants. The semiconductor structure 165 is at least partially in the N-well 160. The semiconductor structure 165 may be a P-type semiconductor structure. In some embodiments, the semiconductor structure 165 includes one or more semiconductor materials and one or more P-type dopants. The semiconductor structure 135, 145, or 165 may be formed through an epitaxial deposition process followed by a doping process.

The electrically conductive structure 170 has a first portion (e.g., the vertical section on the left) over the semiconductor structure 135, a second portion (e.g., the vertical section on the right) over the semiconductor structure 145, and a third portion (e.g., the horizontal portion) connected to the first portion and the second portion. With the electrically conductive structure 170, the semiconductor structure 135 and the semiconductor structure 145 may be at the same electrical potential. The electrically conductive structure 170 may constitute a terminal of the IC device 100. In some embodiments, the electrically conductive structure 170 is electrically coupled to a power plane or ground plane associated with the IC device 100. In an embodiment, the electrically conductive structure 170 is electrically coupled to VSS.

The electrically conductive structure 180 is over the semiconductor structure 165 and may constitute another terminal of the IC device 100. The electrically conductive structure 180 may be separated from the electrically conductive structure 170 by the electrical insulator 115 or one or more other electrical insulators. In some embodiments, the electrically conductive structure 170 is electrically coupled to a power plane or ground plane associated with the IC device 100. In an embodiment, the electrically conductive structure 170 is electrically coupled to a power plane.

The gate electrodes 190 are over the P-well 130, P-well 140, and N-well 160. A gate electrode 190 may extend in a direction that is perpendicular to a plane of the support structure 110. The semiconductor structures 135, 145, and 165 are each between a pair of gate electrodes 190. Even though FIG. 1 shows six gate electrodes 190, the IC device 100 may include a different number of gate electrodes 190. The gate electrodes 190 are electrically conductive and are separated from each other by the electrical insulator 115 or one or more other electrical insulators. A gate electrode 190 may include a metal, polycrystalline silicon (poly), etc.

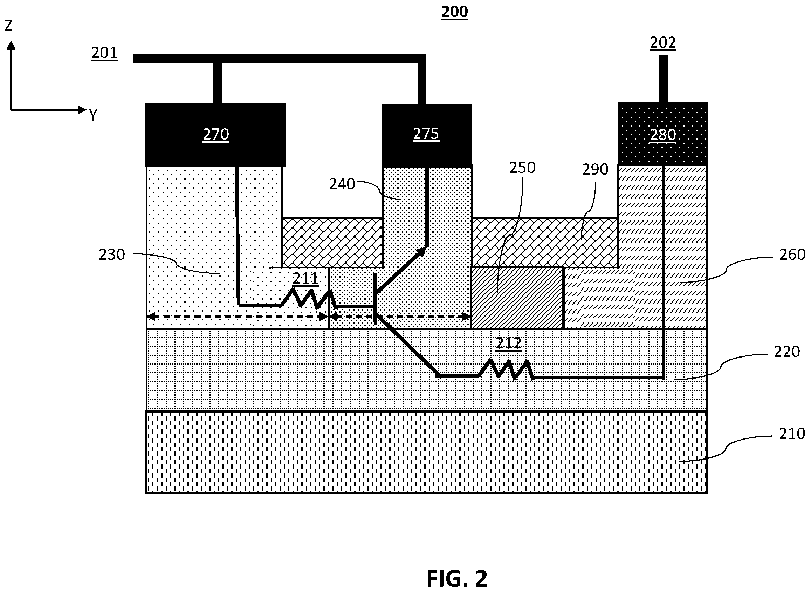

FIG. 2 illustrates a circuit diagram of an IC device 200 with two terminals 201 and 202, according to some embodiments of the disclosure. An embodiment of the IC device 200 may be the IC device 100 in FIG. 1. As shown in FIG. 2, the IC device 200 includes a support structure 210, an electrical insulator 215, a layer 220, a P-well 230, another P-well 240, a well 250, a N-well 260, and contacts 270, 275, and 280. In other embodiments, the IC device 200 may include different, fewer, or more components.

The support structure 210 may be a P-type substrate. The support structure 210 may be an embodiment of the support structure 110 in FIG. 1. The electrical insulator 215 may include a dielectric material, hysteretic material, and so on. The electrical insulator 215 may be an embodiment of the electrical insulator 115. The layer 220 may include a deep N-well. The layer 220 may be an embodiment of the deep N-well 120 in FIG. 1.

The P-well 230, P-well 240, well 250, and N-well 260 are over the layer 220. The P-well 240 is between the P-well 230 and the well 250. The well 250 is between the P-well 240 and the N-well 260. The P-well 230 may be an embodiment of the P-well 130. The P-well 240 may be an embodiment of the P-well 140. The well 250 may be an embodiment of the well 150. The N-well 260 may be an embodiment of the N-well 160.

The contacts 270, 275, and 280 may each include an electrical conductor, e.g., metal, etc. The contact 270 is over the P-well 230. The contact 275 is over the P-well 240. The contact 270 and contact 275 are both coupled to a terminal 201 of the IC device 200. The contact 280 is over the N-well 260 and is coupled to another terminal 202 of the IC device 200. The terminal 201 and terminal 202 may be at different electrical potentials.

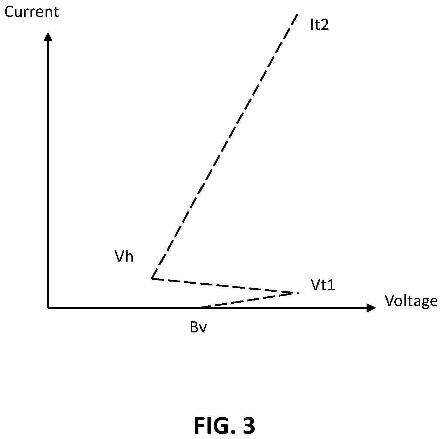

The IC device 200 may constitute a BJT, such as an N-P-N BJT. The P-well 230 (optionally including one or more semiconductor structures in the P-well 230) may be the base. Also, the P-well 240 (optionally including one or more semiconductor structures in the P-well 240) may be the emitter, and the N-well 260 (optionally including one or more semiconductor structures in the N-well 260) may be the collector. The BJT has a base resistance 211 and a collector resistance 212. The base resistance 211 can be modulated through the doping of the P-well 130 or P-well 140 or spacing of emitter. The collector resistance 212 can be modulated through the doping of the layer 220 and conductance path to collector. Certain aspects of performance characteristics of the IC device are described below in conjunction with FIG. 3.

FIG. 3 illustrates a voltage-current curve of an IC device with two terminals, according to some embodiments of the disclosure. The IC device may be used for ESD protection. The IC device may be an embodiment of the IC device 100 in FIG. 1 or the IC device 200 in FIG. 2. The voltage-current curve in FIG. 3 indicates performance characteristics of the IC device. The voltage-current curve shows a breakdown voltage (BV), trigger voltage (Vt1), and holding voltage (Vh). These voltages may be modulated using dopant tunning and device architecture/design to meet a requirement of the parent circuit to avoid false trigger of the IC device during regular DC operation. Also, it would not be late to turn on to prevent breakdown of victim devices in the circuit.

During ESD operation, the N-well/P-well breaks down at a voltage, i.e., breakdown voltage (BV), and an avalanche current flow occurs. The breakdown voltage can be modulated by the spacing or doping of the P-well 140, well 150, or N-well 160. The emitter- base voltage may increase until the BJT triggers a voltage, i.e., trigger voltage (Vt1). This trigger voltage can be modulated by the base resistance Rb, e.g., the base resistance 211. The device then snapbacks into a low resistive mode and reaches a holding voltage (Vh), which can be tuned independently by modulating the gain of the base. The IC device can sink sufficient peak current (It2). The collector resistance (Rc), e.g., the collector resistance 212, can be modulated through doping of the deeper N-well and conductance path to collector. The IC can be self-sufficient and not require additional resistor on the base to trigger faster or a ballast resistance on the collector to uniformly conduct current to sustain a higher peak current (It2).

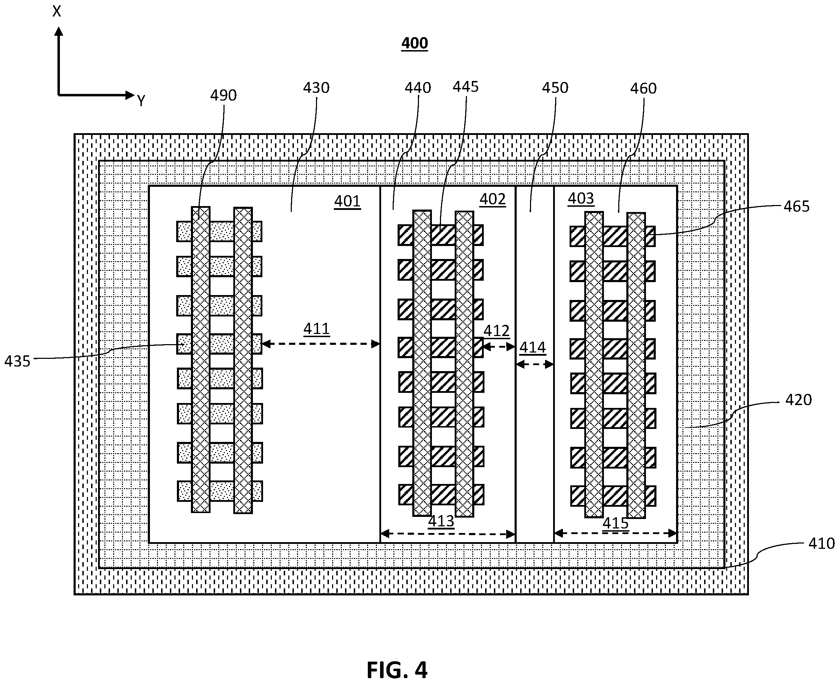

FIG. 4 is a top view of an IC device 400 with two terminals, according to some embodiments of the disclosure. The IC device 400 may be an embodiment of the IC device 100 in FIG. 1 or the IC device 200 in FIG. 2. As shown in FIG. 4, the IC device 400 includes a base section 401, an emitter section 402, a collector section 403, a well 450, a support structure 410, and a deep N-well 420. In other embodiments, the IC device 200 may include different, fewer, or more components.

The support structure 410 may be a P-type substrate. The support structure 410 may be an embodiment of the support structure 110 in FIG. 1. The deep N-well 420 is over the support structure 410. The deep N-well 420 may be an embodiment of the deep N-well 120 in FIG. 1. The base section 401, emitter section 402, and collector section 403 are over the deep N-well 120.

The base section 401 includes a well 430, semiconductor structures 435 (individually referred to as "semiconductor structure 435"), and two gates 490 (individually referred to as "gate 490"). The well 430 may be over a portion of the deep N-well 420. In some embodiments, the well 430 may enclose at least part of each semiconductor structure 435. The well 430 may include one or more doped semiconductor materials. In some embodiments, the well 430 is a P-well. A semiconductor structure 435 may be a structure formed through epitaxy. A semiconductor structure 435 may include one or more P-type doped semiconductor materials. In some embodiments, a dopant concentration in the semiconductor structure 435 is higher than a dopant concentration in the well 430. A semiconductor structure 435 may be an embodiment of the semiconductor structure 135 in FIG. 1. Each gate 490 crosses the semiconductor structures 435. A gate 490 may be a floating gate. In some embodiments, a gate 490 is not coupled to power plane or ground plane.

The emitter section 402 includes a well 440, semiconductor structures 445 (individually referred to as "semiconductor structure 445"), and two gates 490 (individually referred to as "gate 490"). The well 440 may be over a portion of the deep N-well 420. In some embodiments, the well 440 may enclose at least part of each semiconductor structure 445. The well 440 may include one or more doped semiconductor materials. In some embodiments, the well 440 is a P-well. A semiconductor structure 445 may be a structure formed through epitaxy. A semiconductor structure 445 may include one or more N-type doped semiconductor materials. A semiconductor structure 445 may be an embodiment of the semiconductor structure 145 in FIG. 1. Each gate 490 crosses the semiconductor structures 445. A gate 490 may be a floating gate. In some embodiments, a gate 490 is not coupled to any power plane or ground plane.

The collector section 403 includes a well 460, semiconductor structures 465 (individually referred to as "semiconductor structure 465"), and two gates 490 (individually referred to as "gate 490"). The well 460 may be over a portion of the deep N-well 420. In some embodiments, the well 460 may enclose at least part of each semiconductor structure 465. The well 460 may include one or more doped semiconductor materials. In some embodiments, the well 460 is a N-well. A semiconductor structure 465 may be a structure formed through epitaxy. A semiconductor structure 465 may include one or more N-type doped semiconductor materials. In some embodiments, a dopant concentration in the semiconductor structure 465 is higher than a dopant concentration in the well 460. A semiconductor structure 465 may be an embodiment of the semiconductor structure 145 in FIG. 1. Each gate 490 crosses the semiconductor structures 465. A gate 490 may be a floating gate. In some embodiments, a gate 490 is not coupled to any power plane or ground plane.

The well 450 is between the emitter section 402 and the collector section 403. The well 450 can separate the well 440 from the well 460, e.g., in embodiments where the well 440 and the well 460 have opposite doping types. The well 450 may be over a portion of the deep N-well 420.

Spacing or doping/energy of the wells in the IC device 400 may influence the performance of the IC device 400 for ESD protection. For instance, the doping/energy of the well 430 and a spacing 411 (represented by a dashed arrow) between an edge of the well 430 and an edge of a semiconductor structure 435 may correlated with the trigger voltage (Vt1) of the IC device 400. Also, a spacing 412 (represented by a dashed arrow) between an edge of the well 440 and an edge of a semiconductor structure 445 may correlated with a ratio of the holding voltage (Vh) to the trigger voltage (Vt1) of the IC device 400. The doping/energy of the well 440 or a width 413 of the well 440 may correlate with the trigger voltage (Vt1) and the holding voltage (Vh). A width 414 of the well 450 along the Y axis may correlated with the breakdown voltage (BV) of the IC device 400. A width 415 of the well 460 along the Y axis may correlated with a ratio of a resistance (Ron) to a peak current (It2) of the IC device 400. Thus, by tuning the spacing or doping/energy of the wells, the ESD protection performance of the IC device 400 can be optimized. The spacing 411 may be in a range from approximately 300 nm to approximately 900 nm. The spacing 412 or the width 414 may be in a range from approximately 100 nm to approximately 350 nm.

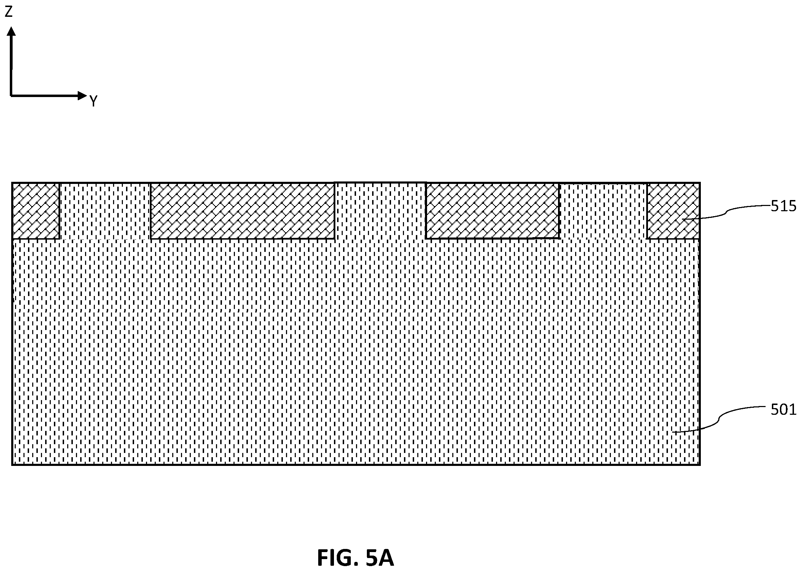

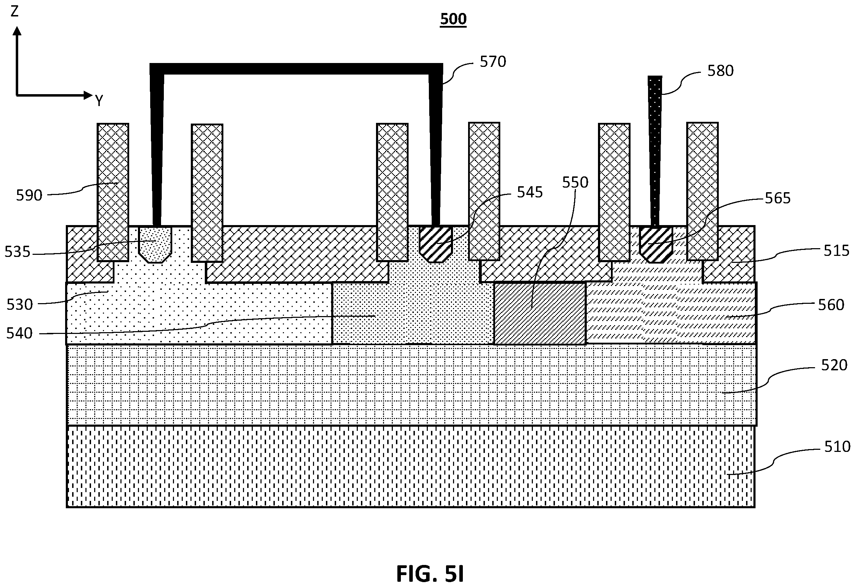

FIGS. 5A-5I illustrate a process of forming a two-terminal IC device 500, according to some embodiments of the disclosure. The IC device 500 is shown in FIG. 5I. The IC device 500 may be an embodiment of the IC device 100 in FIG. 1, the IC device 200 in FIG. 2, or the IC device 400 in FIG. 4. In some embodiments, each of the FIGS. 5A-5I may represent a step in the process of forming the IC device 500. In other embodiments, a figure may represent more than one step or part of a step in the process. Also, the sequence of the FIGS. 5A-5I may not represent the order in which the components of the IC device 500 are formed. For instance, a component shown in a figure may be formed before a component shown in a previous figure. Although the process is described with reference to FIGS. 5A-5I, other processes for forming two-terminal IC devices may be alternatively used. For instance, some of the steps described in conjunction with FIGS. 5A-5I may be changed, eliminated, or combined.

In FIG. 5A, a support structure 501 is provided. The support structure 501 may be a semiconductor substrate composed of semiconductor material systems. In some embodiments, the support structure 501 may be a P-type substrate. In some embodiments, the semiconductor substrate may be a crystalline substrate formed using a bulk silicon or a silicon-on-insulator substructure. In other embodiments, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. In some embodiments, the substrate may be non-crystalline. An electrical insulator 515 is also provided. The electrical insulator 515 may be at least partially enclosed by the support structure 501.

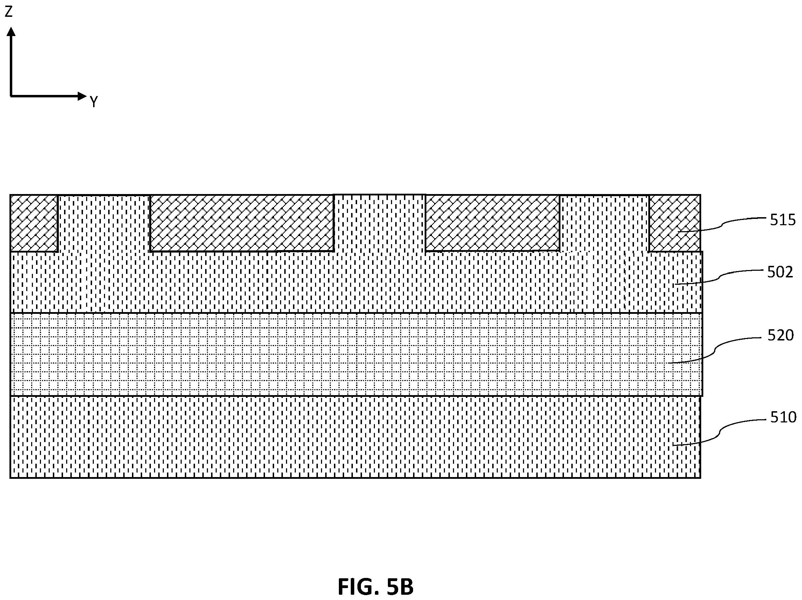

In FIG. 5B, a deep N-well 520 is formed in the support structure 501. The deep N-well 520 may be formed by diffusing or implanting N-type dopants into a region in the support structure 501, e.g., the region between a region 502 and a region 510. The region 510 may be an embodiment of the support structure 110 in FIG. 1, the support structure 210 in FIG. 2, or the support structure 410 in FIG. 4.

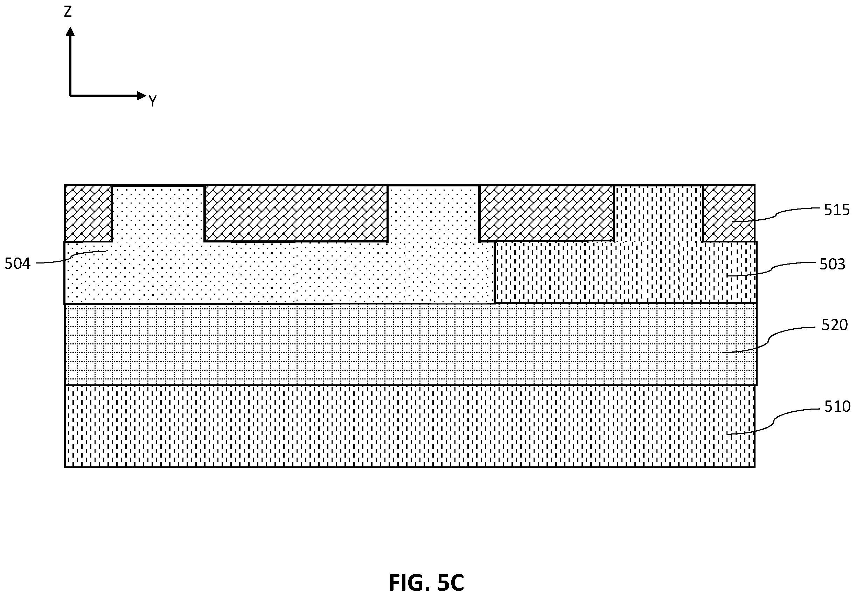

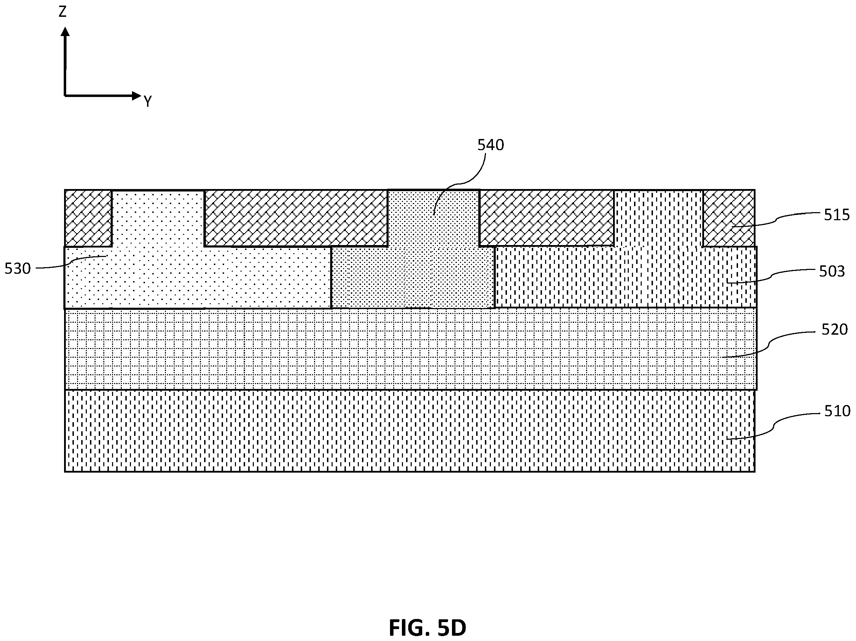

In FIG. 5C, a P-well 504 is formed by doping a portion of the region 502, i.e., the region 502 excluding a region 503. The P-well 504 may be doped through diffusing or implanting P-type dopants into the portion of the region 502. In FIG. 5D, a portion of the P-well 504 is further doped, which forms a P-well 530 and a P-well 540 with different dopant concentrations energy levels. In some embodiments, the dopant concentration in the P-well 540 may be approximately 2.5 to 6 times the dopant concentration in the P-well 504 or 530. The dopant concentration in the P-well 530 may be the same or substantially similar as the dopant concentration in the P-well 504. The P-well 530 may be an embodiment of the P-well 130, 230, or 430. The P-well 540 may be an embodiment of the P-well 140, 240, or 440. The doping for forming the P-well 504 and the P-well 540 may be modulated to optimize the performance of the IC device 500 for ESD protection.

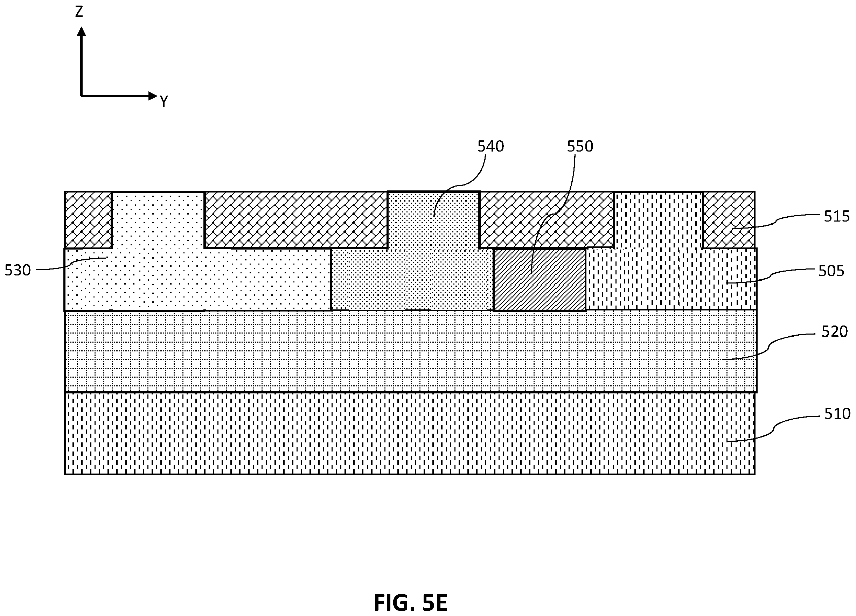

In FIG. 5E, a well 550 is formed by doping a portion of the region 503, i.e., the region 503 excluding a region 505. The well 550 can tune the breakdown voltage of the IC device 500. The doping may be N-type doping or P-type doping. The well 550 may be an embodiment of the well 150, 250, or 450.

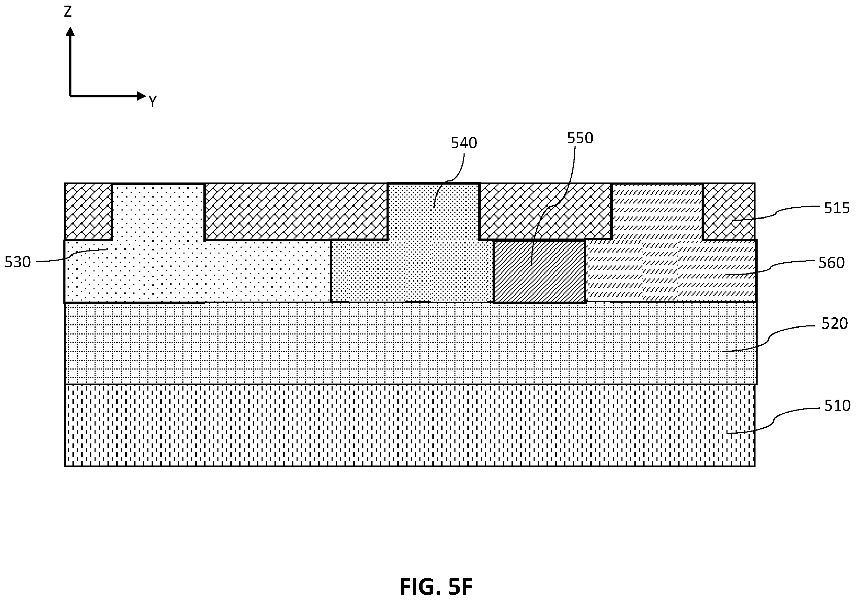

In FIG. 5F, a N-well 560 is formed by doping the region 505. The N-well 560 may be formed by diffusing or implanting N-type dopants into N-well 560. The dopant concentration in the N-well 560 may be approximately the same as the dopant concentration in the P-well 540 but higher than the dopant concentration of the well 550. In some embodiments, the dopant concentration in the N-well 560 may be at least twice the dopant concentration of the well 550.

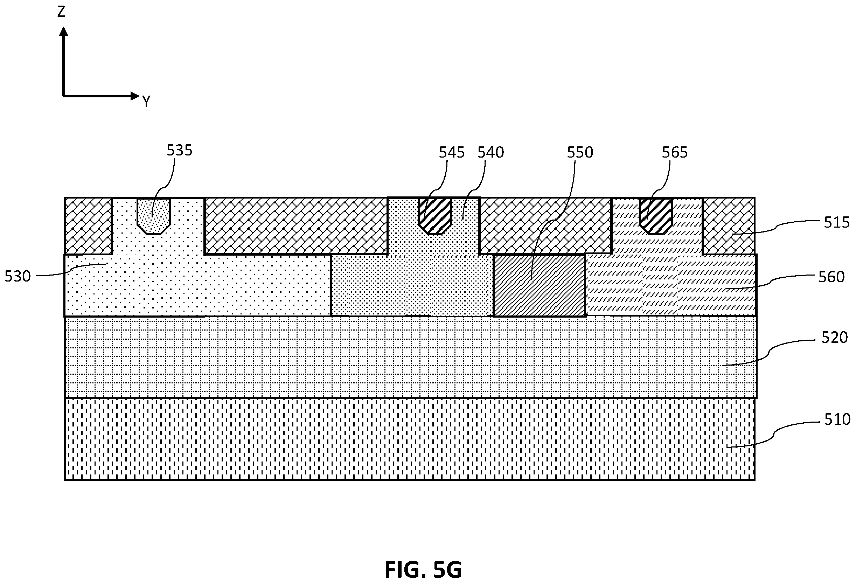

In FIG. 5G, semiconductor structures 535, 545, and 565 are formed. In some embodiments, the semiconductor structure 535 is at least partially inside the P-well 530. The semiconductor structure 535 may be a P-type semiconductor structure. The semiconductor structure 535 may be formed through an epitaxial deposition process, which may be followed by a P-type doping process. The semiconductor structure 535 may include P-type dopants, such as Boron or other P-type dopants. The semiconductor structure 535 may be an embodiment of the semiconductor structure 135 in FIG. 1 or the semiconductor structure 435 in FIG. 4.

The semiconductor structure 545 is at least partially inside the P-well 540. The semiconductor structure 545 may be an N-type semiconductor structure. The semiconductor structure 545 may be formed through an epitaxial deposition process, which may be followed by an N-type doping process. The semiconductor structure 545 may be an embodiment of the semiconductor structure 145 in FIG. 1 or the semiconductor structure 445 in FIG. 4.

The semiconductor structure 565 is at least partially inside the N-well 560. The semiconductor structure 565 may be an N-type semiconductor structure. The semiconductor structure 565 may be formed through an epitaxial deposition process, which may be followed by an N-type doping process. The semiconductor structure 565 may be an embodiment of the semiconductor structure 165 in FIG. 1 or the semiconductor structure 465 in FIG. 4. The semiconductor structure 545 or 565 may include N-type dopants, such as Arsenic, Phosphorus, or other N-type dopants. The dopant concentration of the semiconductor structure 535, 545, or 565 may be in a range from approximately 1×1021 atoms/cm³ to approximately 1×10²² atoms/cm³. The dopant concentration of the N-well 560 may be in a range from approximately 1.5×10¹⁸ atoms/cm³ to approximately 3.5×10¹⁸ atoms/cm³.

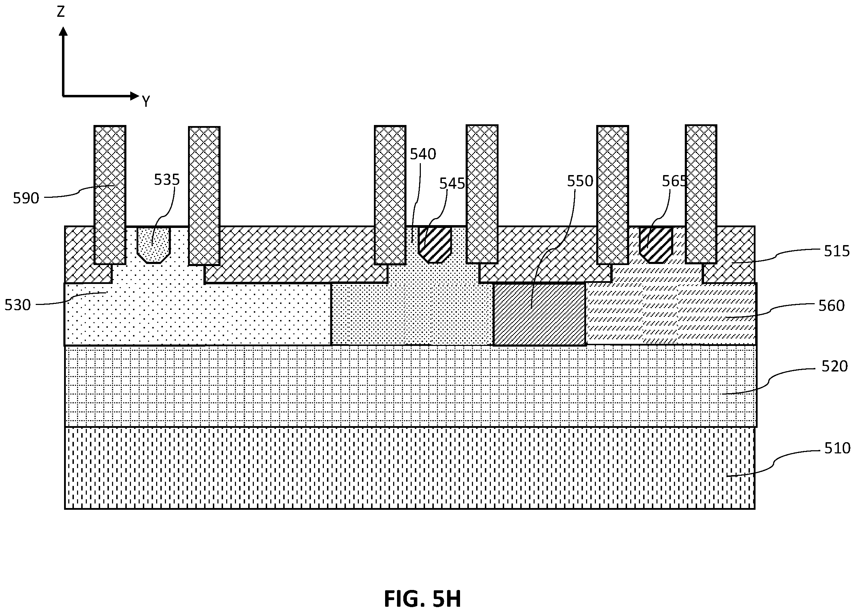

In FIG. 5H, gates 590 (individually referred to as "gate 590") are formed. A portion of a gate 590 is in a well or the electrical insulator 515. A gate 590 may include a metal, poly, or other types of conductive materials. Even though FIG. 5H shows six gates 590, a different number of gates 590 can be formed. Also, the positions of the gates 590 can be different from their positions in FIG. 5H. The gates 590 may be floating. In some embodiments, the gates 590 may not impact the performance of the IC device 500 for ESD protection.

In FIG. 5I, two conductive structures 570 and 580 are formed. The conductive structure 570 is connected to the semiconductor structure 535 and the semiconductor structure 545 so that the P+ base and the N+ epitaxies of the emitter are shorted together. In some embodiments, the conductive structure 570 is grounded. For instance, the conductive structure is coupled to VSS. The conductive structure 580 is connected to the semiconductor structure 565. In some embodiments, the conductive structure 580 is coupled to a power plane so that the N+ epitaxy of the collector is connected to power.

FIGS. 6A-6B are top views of a wafer 2000 and dies 2002 that may facilitate one or more two-terminal IC devices for ESD protection, according to some embodiments of the disclosure. In some embodiments, the dies 2002 may be included in an IC package, according to some embodiments of the disclosure. For example, any of the dies 2002 may serve as any of the dies 2256 in an IC package 2200 shown in FIG. 7. The wafer 2000 may be composed of semiconductor material and may include one or more dies 2002 having IC devices formed on a surface of the wafer 2000. Each of the dies 2002 may be a repeating unit of a semiconductor product that includes any suitable IC (e.g., ICs including two terminals as described herein). After the fabrication of the semiconductor product is complete (e.g., after manufacture of two-terminal IC devices as described herein), the wafer 2000 may undergo a singulation process in which each of the dies 2002 is separated from one another to provide discrete "chips" of the semiconductor product. In particular, two-terminal IC devices as disclosed herein may take the form of the wafer 2000 (e.g., not singulated) or the form of the die 2002 (e.g., singulated). The die 2002 may include one or more diodes, one or more transistors as well as, optionally, supporting circuitry to route electrical signals to the III-N diodes with N-doped wells and capping layers and III-N transistors, as well as any other IC components. In some embodiments, the wafer 2000 or the die 2002 may implement an ESD protection device, a radio frequency front-end device, a memory device (e.g., a static random-access memory (SRAM) device), a logic device (e.g., an AND, OR, NAND, or NOR gate), or any other suitable circuit element. Multiple ones of these devices may be combined on a single die 2002.

FIG. 7 is a side, cross-sectional view of an example IC package 2200 that may include one or more two-terminal IC devices for ESD protection, according to some embodiments of the disclosure. In some embodiments, the IC package 2200 may be a system-in-package (SiP).

As shown in FIG. 7, the IC package 2200 may include a package substrate 2252. The package substrate 2252 may be formed of a dielectric material (e.g., a ceramic, a glass, a combination of organic and inorganic materials, a buildup film, an epoxy film having filler particles therein, etc., and may have embedded portions having different materials), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 7 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 7 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

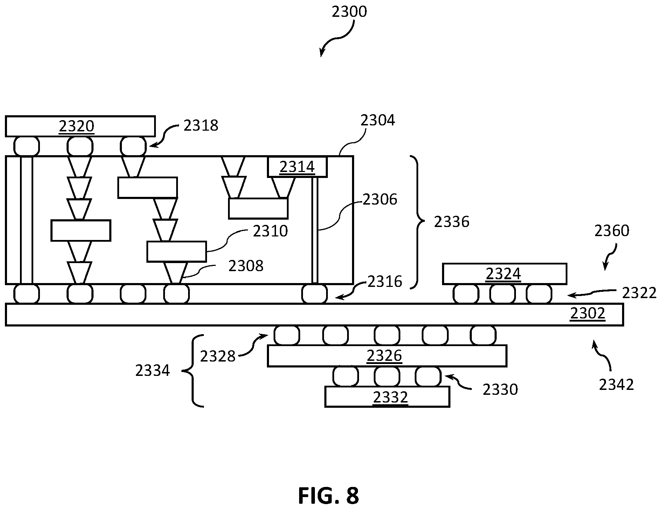

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 7 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 8.

The dies 2256 may take the form of any of the embodiments of the die 2002 discussed herein and may facilitate any of the embodiments of a two-terminal IC device. In embodiments in which the IC package 2200 includes multiple dies 2256, the IC package 2200 may be referred to as a multi-chip package. Importantly, even in such embodiments of an MCP implementation of the IC package 2200, one or more two-terminal IC devices may be provided in a single chip, in accordance with any of the embodiments described herein. The dies 2256 may include circuitry to perform any desired functionality. For example, one or more of the dies 2256 may be ESD protection dies, including one or more two-terminal IC devices described herein, one or more of the dies 2256 may be logic dies (e.g., silicon-based dies), one or more of the dies 2256 may be memory dies (e.g., high bandwidth memory), etc. In some embodiments, any of the dies 2256 may include one or more two-terminal IC devices, e.g., as discussed above; in some embodiments, at least some of the dies 2256 may not include any III-N diodes with N-doped wells and capping layers.

The IC package 2200 illustrated in FIG. 7 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 7, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 8 is a cross-sectional side view of an IC device assembly 2300 that may include components having one or more two-terminal IC devices for ESD protection, according to some embodiments of the disclosure. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of the IC devices having two terminals in accordance with any of the embodiments disclosed herein; e.g., any of the IC packages discussed below with reference to the IC device assembly 2300 may take the form of any of the embodiments of the IC package 2200 discussed above with reference to FIG. 7 (e.g., may include one or more two-terminal IC devices in/on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 8 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 8), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 6B), an IC device (e.g., the IC device of FIGS. 1-2), or any other suitable component. In particular, the IC package 2320 may include one or more two-terminal IC devices as described herein. Although a single IC package 2320 is shown in FIG. 8, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 8, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to TSVs 2306. The interposer 2304 may further include embedded devices 2314, including both passive and active devices. Such devices may include, but are not limited to, capacitors, decoupling capacitors, resistors, inductors, fuses, diodes, transformers, sensors, ESD protection devices, and memory devices. More complex devices such as further RF (radio frequency) devices, power amplifiers, power management devices, antennas, arrays, sensors, and microelectromechanical systems (MEMS) devices may also be formed on the interposer 2304. In some embodiments, the IC devices having two terminals as described herein may also be implemented in/on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 8 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

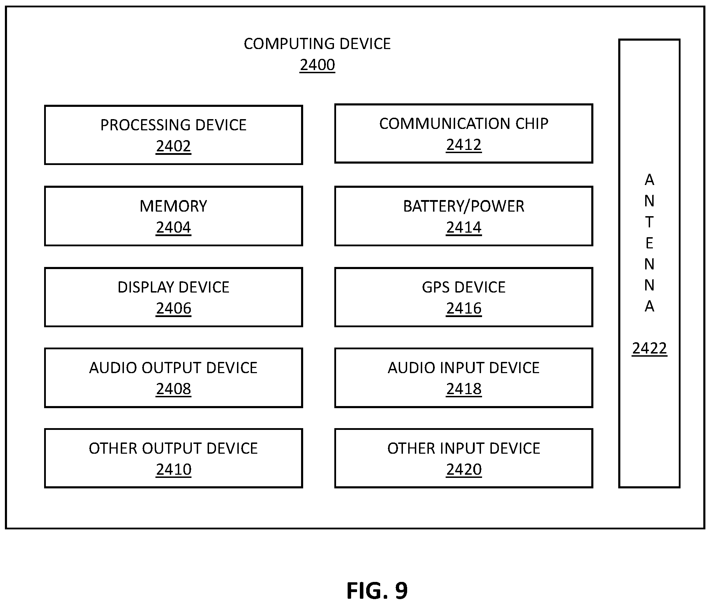

FIG. 9 is a block diagram of an example computing device 2400 that may include one or more components with one or more two-terminal IC devices, according to some embodiments of the disclosure. For example, any suitable ones of the components of the computing device 2400 may include a die (e.g., the die 2002 of FIG. 6B) including one or more two-terminal IC devices, according to some embodiments of the disclosure. Any of the components of the computing device 2400 may include one or more two-terminal IC devices (e.g., any embodiment of two-terminal IC devices described above in conjunction with FIGS. 1-4 and 5A-5I) and/or an IC package (e.g., the IC package 2200 of FIG. 7). Any of the components of the computing device 2400 may include an IC device assembly (e.g., the IC device assembly 2300 of FIG. 8).

A number of components are illustrated in FIG. 9 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC (system-on-chip) die.

Additionally, in various embodiments, the computing device 2400 may not include one or more of the components illustrated in FIG. 9, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid-state memory, and/or a hard drive. In some embodiments, the memory 2404 may include memory that shares a die with the processing device 2402. This memory may be used as cache memory and may include, e.g., eDRAM, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

In various embodiments, IC devices having two terminals as described herein may be particularly advantageous for use as part of ESD circuits protecting power amplifiers, low-noise amplifiers, filters (including arrays of filters and filter banks), switches, or other active components. In some embodiments, IC devices having two terminals as described herein may be used in PMICs, e.g., as a rectifying diode for large currents. In some embodiments, IC devices having two terminals as described herein may be used in audio devices and/or in various input/output devices.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include another output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include another input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

The following paragraphs provide various examples of the embodiments disclosed herein.

Example 1 provides an IC device, including a layer including a first doped semiconductor material with a first doping type; a first region over the layer, the first region including a second doped material with a second doping type that is opposite from the first doping type; a second region over the layer, the second region including a third doped semiconductor material with the second doping type; a first structure including a fourth doped semiconductor material with the second doping type, the first structure at least partially surrounded by the first region; a second structure including a fifth doped semiconductor material with the first doping type, the second structure at least partially surrounded by the second region; and an electrically conductive structure including a first portion over the first structure and a second portion over the second structure.

Example 2 provides the IC device according to example 1, further including a third region over the layer, the third region including a sixth doped semiconductor material with the first doping type; and a third structure including a seventh doped semiconductor material with the first doping type, the third structure at least partially surrounded by the third region, where the second region is between the first region and the third region.

Example 3 provides the IC device according to example 2, further including an additional electrically conductive structure over the third structure, where the additional electrically conductive structure is separated from the electrically conductive structure by an electrical insulator.

Example 4 provides the IC device according to example 3, where the additional electrically conductive structure is electrically coupled to a power plane, and the electrically conductive structure is electrically coupled to a ground plane.

Example 5 provides the IC device according to any of the preceding examples, where a dopant concentration in the second region is at least 2.5 times higher than a dopant concentration in the first region.

Example 6 provides the IC device according to any of the preceding examples, where the first region or the second region is over the layer in a first direction, and a dimension of the first region in a second direction perpendicular to the first dimension is larger than a dimension of the second region in the second direction.

Example 7 provides the IC device according to any of the preceding examples, further including a third region over the layer, the third region including a sixth doped semiconductor material with the first doping type, where a dopant concentration in the third region is no more than half of a dopant concentration in the second region, and the second region is between the first region and the third region.

Example 8 provides an IC device, including a base section including a first P-well and a P-type semiconductor structure; an emitter section including a second P-well and a first N-type semiconductor structure; a collector section including a N-well and a second N-type semiconductor structure; a N-well over at least one of the base section, the emitter section, and the collector section; a first contact electrically coupled to the P-type semiconductor structure and the first N-type semiconductor structure; and a second contact electrically coupled to the second N-type semiconductor structure.

Example 9 provides the IC device according to example 8, where a distance from an edge of the P-type semiconductor structure to an edge of the first P-well in a direction is greater than a distance from an edge of the first N-type semiconductor structure to an edge of the second P-well.

Example 10 provides the IC device according to example 8 or 9, further including a P-doped substrate over the N-well, where the N-well is between the P-doped substrate and at least one of the base section, the emitter section, and the collector section.

Example 11 provides the IC device according to any one of examples 8-10, where the base section further includes a gate, and at least part of the gate is over the P-type semiconductor structure.

Example 12 provides the IC device according to any one of examples 8-11, where the P-type semiconductor structure, the first N-type semiconductor structure, or the second N-type semiconductor structure includes a fin or nanoribbon.

Example 13 provides the IC device according to any one of examples 8-12, further including an electrical insulator between the first P-well and the second P-well.

Example 14 provides the IC device according to any one of examples 8-13, where a dopant concentration in the first P-well is lower than a dopant concentration in the second P-well or the N-well.

Example 15 provides a method for forming an IC device, including forming an N-well in a substrate, the N-well between a first portion of the substrate and a second portion of the substrate in a first direction; forming a first P-well in the first portion of the substrate by doping a first part of the first potion of the substrate; forming a second P-well in the first portion of the substrate by doping a second part of the first potion of the substrate; forming a N-well in the first portion of the substrate by doping a third part of the first potion of the substrate, where the second part is between the first part and the third party in a second direction that is perpendicular to the first direction; forming a first semiconductor structure in the first P-well; forming a second semiconductor structure in the second P-well; and forming a third semiconductor structure in the N-well.

Example 16 provides the method according to example 15, further including forming an electrically conductive structure, a first portion of the electrically conductive structure over the first semiconductor structure, a second portion of the electrically conductive structure over the second semiconductor structure.

Example 17 provides the method according to example 15 or 16, further including forming an electrically conductive structure over the third semiconductor structure.

Example 18 provides the method according to any one of examples 15-17, further including forming a well in the first portion of the substrate by doping a fourth part of the first potion of the substrate, where the fourth part is between the second part and the third party in the second direction.

Example 19 provides the method according to example 18, where forming the well includes forming the well before forming the N-well.

Example 20 provides the method according to any one of examples 15-19, further including after forming the N-well, forming a gate over the first semiconductor structure, the second semiconductor structure, or the third semiconductor structure in the second direction.

Example 21 provides an IC package, including the IC device according to any one of examples 1-14; and a further IC component, coupled to the device.

Example 22 provides the IC package according to example 21, where the further IC component includes one of a package substrate, an interposer, or a further IC die.

Example 23 provides the IC package according to example 21 or 22, where the IC device according to any one of examples 1-14 may include, or be a part of, at least one of a memory device, a computing device, a wearable device, a handheld electronic device, and a wireless communications device.

Example 24 provides an electronic device, including a carrier substrate; and one or more of the IC device according to any one of examples 1-14 and the IC package according to any one of examples 21-23, coupled to the carrier substrate.

Example 25 provides the electronic device according to example 24, where the carrier substrate is a motherboard.

Example 26 provides the electronic device according to example 24, where the carrier substrate is a PCB.

Example 27 provides the electronic device according to any one of examples 24-26, where the electronic device is a wearable electronic device or handheld electronic device.

Example 28 provides the electronic device according to any one of examples 24-27, where the electronic device further includes one or more communication chips and an antenna.

Example 29 provides the electronic device according to any one of examples 24-28, where the electronic device is an RF transceiver.

Example 30 provides the electronic device according to any one of examples 24-28, where the electronic device is one of a switch, a power amplifier, a low-noise amplifier, a filter, a filter bank, a duplexer, an upconverter, or a downconverter of an RF communications device, e.g., of an RF transceiver.

Example 31 provides the electronic device according to any one of examples 24-30, where the electronic device is a computing device.

Example 32 provides the electronic device according to any one of examples 24-31, where the electronic device is included in a base station of a wireless communication system.

Example 33 provides the electronic device according to any one of examples 24-31, where the electronic device is included in a user equipment device of a wireless communication system.

Example 34 provides the method according to any one of examples 15-20, further including processes for forming the IC device according to any one of claims 1-14.

Example 35 provides the method according to any one of examples 15-20, further including processes for forming the IC package according to any one of the claims 21-23.

Example 36 provides the method according to any one of examples 15-20, further including processes for forming the electronic device according to any one of the claims 24-33.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a layer comprising a first doped semiconductor material with a first doping type;
a first region over the layer, the first region comprising a second doped material with a second doping type that is opposite from the first doping type;
a second region over the layer, the second region comprising a third doped semiconductor material with the second doping type;
a first structure comprising a fourth doped semiconductor material with the second doping type, the first structure at least partially surrounded by the first region;
a second structure comprising a fifth doped semiconductor material with the first doping type, the second structure at least partially surrounded by the second region; and
an electrically conductive structure comprising a first portion over the first structure and a second portion over the second structure.

2. The IC device according to claim 1, further comprising:
a third region over the layer, the third region comprising a sixth doped semiconductor material with the first doping type; and
a third structure comprising a seventh doped semiconductor material with the first doping type, the third structure at least partially surrounded by the third region,
wherein the second region is between the first region and the third region.

3. The IC device according to claim 2, further comprising:
an additional electrically conductive structure over the third structure,
wherein the additional electrically conductive structure is separated from the electrically conductive structure by an electrical insulator, the additional electrically conductive structure is electrically coupled to a power plane, and the electrically conductive structure is electrically coupled to a ground plane.

4. The IC device according to any one of claims 1-3, wherein:
a dopant concentration in the second region is at least 2.5 times higher than a dopant concentration in the first region; or
the first region or the second region is over the layer in a first direction, and a dimension of the first region in a second direction perpendicular to the first dimension is larger than a dimension of the second region in the second direction.

5. The IC device according to any one of claims 1-4, further comprising:
a third region over the layer, the third region comprising a sixth doped semiconductor material with the first doping type,
wherein a dopant concentration in the third region is no more than half of a dopant concentration in the second region, and the second region is between the first region and the third region.

6. An integrated circuit (IC) device, comprising:
a base section comprising a first P-well and a P-type semiconductor structure;
an emitter section comprising a second P-well and a first N-type semiconductor structure;
a collector section comprising a N-well and a second N-type semiconductor structure;
a N-well over at least one of the base section, the emitter section, and the collector section;
a first contact electrically coupled to the P-type semiconductor structure and the first N-type semiconductor structure; and
a second contact electrically coupled to the second N-type semiconductor structure.

7. The IC device according to claim 6, wherein a distance from an edge of the P-type semiconductor structure to an edge of the first P-well in a direction is greater than a distance from an edge of the first N-type semiconductor structure to an edge of the second P-well.

8. The IC device according to claim 6 or 7, further comprising:
a P-doped substrate over the N-well,
wherein the N-well is between the P-doped substrate and at least one of the base section, the emitter section, and the collector section.

9. The IC device according to any one of claims 6-8, wherein:
the base section further comprises a gate, and at least part of the gate is over the P-type semiconductor structure; or
the P-type semiconductor structure, the first N-type semiconductor structure, or the second N-type semiconductor structure includes a fin or nanoribbon; or
a dopant concentration in the first P-well is lower than a dopant concentration in the second P-well or the N-well.

10. The IC device according to any one of claims 6-9, further comprising:
an electrical insulator between the first P-well and the second P-well.

11. A method for forming an integrated circuit (IC) device, comprising:
forming an N-well in a substrate, the N-well between a first portion of the substrate and a second portion of the substrate in a first direction;
forming a first P-well in the first portion of the substrate by doping a first part of the first potion of the substrate;
forming a second P-well in the first portion of the substrate by doping a second part of the first potion of the substrate;
forming a N-well in the first portion of the substrate by doping a third part of the first potion of the substrate, wherein the second part is between the first part and the third party in a second direction that is perpendicular to the first direction;
forming a first semiconductor structure in the first P-well;
forming a second semiconductor structure in the second P-well; and
forming a third semiconductor structure in the N-well.

12. The method according to claim 11, further comprising:
forming an electrically conductive structure, a first portion of the electrically conductive structure over the first semiconductor structure, a second portion of the electrically conductive structure over the second semiconductor structure.

13. The method according to claim 11 or 12, further comprising:
forming an electrically conductive structure over the third semiconductor structure; or
forming a well in the first portion of the substrate by doping a fourth part of the first potion of the substrate, wherein the fourth part is between the second part and the third party in the second direction.

14. The method according to claim 13, wherein forming the well comprises:
forming the well before forming the N-well.

15. The method according to any one of claims 11-14, further comprising:
after forming the N-well, forming a gate over the first semiconductor structure, the second semiconductor structure, or the third semiconductor structure in the second direction.
